# EUROPÄISCHE PATENTSCHRIFT

(11) **EP 1 307 923 B1**
(45) Veröffentlichungstag und Bekanntmachung des Hinweises auf die Patenterteilung: **02.11.2005**
(21) Anmeldenummer: 01964927.6
(22) Anmeldetag: 24.08.2001
(51) Int. Cl.: H01L 29/861, H01L 29/06, H01L 21/304

(54) **HOCHVOLT-DIODE UND VERFAHREN ZU DEREN HERSTELLUNG**
HIGH-VOLTAGE DIODE AND METHOD FOR THE PRODUCTION THEREOF
DIODE HAUTE TENSION ET PROCEDE POUR LA PRODUIRE

(30) Priorität: 22.09.2000 DE 10047152
(43) Veröffentlichungstag der Anmeldung: 07.05.2003
(73) Patentinhaber: eupec Europäische Gesellschaft für Leistungshalbleiter mbH & Co. KG, 59581 Warstein (DE); Infineon Technologies AG, 81669 München (DE)
(72) Erfinder: BARTHELMESS, Reiner, 59581 Warstein-Belecke (DE); PFIRSCH, Frank, 81545 München (DE); MAUDER, Anton, 83059 Kolbermoor (DE); SCHMIDT, Gerhard, A-9241 Wernberg-Wudmath (AT)
(74) Vertreter: Kottmann, Heinz Dieter
(86) Internationale Anmeldenummer: PCT/DE2001/003240
(87) Internationale Veröffentlichungsnummer: WO 2002/025740

(56) Entgegenhaltungen:
- EP-A- 0 264 564
- EP-A- 0 341 453
- EP-A- 0 381 111
- EP-A- 0 400 178
- EP-A- 0 760 528
- EP-A- 0 982 768
- US-A- 4 804 641

## Beschreibung

Die vorliegende Erfindung betrifft eine Hochvolt-Diode nach dem Oberbegriff des Patentanspruches 1 sowie ein Verfahren zum Herstellen einer solchen Hochvolt-Diode.

Bisher werden Hochvolt-Dioden, die für höhere Spannungen insbesondere oberhalb von etwa 400 V vorgesehen sind, bei Verwendung von planaren Strukturen mit Randabschlüssen aus Feldplatten, Feldringen, dielektrischen Isolierschichten, semiisolierenden Abdeckungen und variierender Dotierung im Randbereich versehen. Dabei werden diese Maßnahmen einzeln oder in Kombination angewandt, wobei durchaus beispielsweise auch Feldplatten, Feldringe und dielektrische Isolierschichten gemeinsam zum Einsatz kommen.

Dabei hat es sich gezeigt, dass bei der Herstellung der Diode für einen den an ihn gestellten Forderungen genügenden Randabschluss sogar mehr Schritte als zur Einstellung der gewünschten Durchlass- und Schalteigenschaften notwendig sind. So erfordern beispielsweise Diodenränder auf der Basis von Feldplatten relativ aufwändige Herstellungsprozesse.

Im Einzelnen sind in C. Mingues und G. Charitat: "Efficiency of Junction Termination Techniques vs. Oxide Trapped Charges", 1997, IEEE International Symposium on Power Semiconductor Devices and ICs, Weimar, Seiten 137 bis 140, Randabschlüsse mit Feldringen, semiisolierenden Schichten oder einer JTE (Junction Termination Extension) speziell hinsichtlich ihrer Empfindlichkeit gegenüber Oxydladungen miteinander verglichen. Dabei werden für Hochspannungsanwendungen als semiisolierende Schichten der Einsatz von SIPOS-Techniken empfohlen.

EP-A-760 528 offenbert eine Diode mit Randabschluß. EP-A- 264 564 zeigt einen Temperatursensor mit Chipping Stopper.

Aus EP-B1-0 341 453 ist ein MOS-Halbleiterbauelement für hohe Sperrspannung bekannt, bei dem Feldplatten auf verschieden dicken Isolierschichten angeordnet sind. Einige dieser Feldplatten dienen dabei als Kanal- bzw. Channel-Stopper. Solche als Kanal-Stopper verwendeten Feldplatten werden bei Dioden oft durch ein p-leitendes Gebiet im Randbereich an das Rückseitenpotenzial der Diode angeschlossen, obwohl an sich ein Anschluss über ein n-leitendes Gebiet vorteilhafter wäre, weil dadurch ein p-leitender Kanal zuverlässig verhindert werden könnte. Allerdings wäre für einen solchen Anschluss über ein n-leitendes Gebiet bei einem sonst üblichen Herstellungsprozess ein zusätzlicher Maskenschritt erforderlich.

So genannte Chipping-Stopper sollen beim Sägen einer Scheibe in einzelne Chips eine Ausbreitung von Kristalldefekten von der Sägekante in das aktive Gebiet der jeweiligen Chips verhindern. Diese Chipping-Stopper werden üblicherweise durch ein Feldoxid zwischen dem funktionellen Randbereich des Chips und dem Sägerahmen realisiert.

Werden hoch sperrende pn-Übergänge nur mit dielektrischen Passivierungsschichten abgedeckt, so können bei Einwirkung von äußeren Ladungen, die beispielsweise auf Feuchtigkeit, alkalische oder metallische Kontamination etc. zurückzuführen sind, bei Sperrbelastung des pn-Überganges Veränderungen in der Langzeit-Sperrstabilität beobachtet werden. Diese Veränderungen werden durch Drift von Ionenladungen im elektrischen Feld des in Sperrrichtung gepolten pn-Überganges auf oder in der Passivierungsschicht hervorgerufen. Abhängig von dem Vorzeichen der Ionenladungen und auch abhängig von der Struktur des Randabschlusses, also abhängig von der so genannten Randkontur, können die Ionenladungen zu einer Erhöhung oder zu einer Erniedrigung der Sperrfähigkeit des pn-Überganges führen. Bei einer Diode mit p-leitender Anode nimmt dabei mit abnehmender Dotierung in der n-leitenden Basis und daher mit zunehmender Volumensperrfähigkeit der Diode durch eine größere Influenzwirkung der Einfluss solcher Oberflächenladungen in und auf der Passivierungsschicht zu, was zu einer dramatischen Steigerung der Gefahr von Sperrinstabilitäten führt. In diesem Zusammenhang ist auf den so genannten Yoshida-Effekt zu verweisen: Bei Einsatz von Isolatorschichten zur Passivierung wird gelegentlich infolge einer Injektion von heißen Elektronen während der Durchlassbelastung beim Umschalten in den Sperrzustand des pn-Überganges eine Drift der Sperrspannung beobachtet.

Durch den Einsatz von semiisolierenden Schichten direkt auf den pn-Übergängen kann bei geeigneten Einstellungen der Schicht- und Grenzflächenparameter, wie beispielsweise der Schichtdicke und Dotierung der semiisolierenden Schichten, der Einfluss solcher Oberflächenladungen unterdrückt werden. Die semiisolierenden Schichten, die derzeit zur Passivierung von pn-Übergängen eingesetzt werden, bestehen beispielsweise aus amorphem Silizium (a-Si) oder aus mit Wasserstoff dotier-tem amorphem Kohlenstoff (a-C:H), wie sie in EP-B1-0 400 178 und EP-B1-0 381 111 beschrieben sind. Mit diesen semiisolie-renden Schichten können bei entsprechender Optimierung der amorphkristallinen Heteroübergänge zwischen diesen Schichten und dem elektrisch aktiven Siliziumsubstrat parasitäre Effek-te, wie ein erhöhter Sperrstrom oder die Ausbildung von Inversionsschichten, vermieden werden. Außerdem können semiisolierende Passivierungsschichten durch ihre endliche Zustandsdichte aktiv Bildladungen aufbauen und so von außen eindringende Fremdladungen abschirmen sowie durch ihre endliche spezifische Leitfähigkeit injizierte Ladungsträger ableiten. Insgesamt führt so eine semiisolierende Passivierung gegenüber einer dielektrischen Passivierung zu einer wesentlich verbesserten Langzeitstabilität.

Es ist Aufgabe der vorliegenden Erfindung, eine Hochvolt-Diode für Sperrspannungen insbesondere über etwa 400 V und vorzugsweise über etwa 500 V anzugeben, welche mit möglichst geringer Prozesskomplexität und damit geringer Anzahl von Fototechniken herstellbar ist und im Randbereich ohne Weiteres mit einem Kanal-Stopper zur Vermeidung von Leckströmen und einem Chipping-Stopper zur Begrenzung der Ausdehnung von Sägedefekten ausgestattet werden kann; außerdem soll ein Verfahren zum Herstellen einer solchen Hochvolt-Diode geschaffen werden.

Diese Aufgabe wird bei einer Hochvolt-Diode nach dem Oberbegriff des Patentanspruches 1 erfindungsgemäß durch die in dessen kennzeichnendem Teil enthaltenen Merkmale gelöst.

Ein vorteilhaftes Verfahren zum Herstellen der erfindungsgemäßen Hochvolt-Diode ist in Patentanspruch 12 angegeben.

Vorteilhafte Weiterbildungen der Erfindung ergeben sich aus den Unteransprüchen.

Die im kennzeichnenden Teil des Patentanspruches 1 angegebenen Maßnahmen (a) und (b) dienen jede einzeln für sich dazu, eine Hochvolt-Diode zu ermöglichen, die mit geringem Aufwand für Masken und Justage herstellbar ist und über einen Kanal-Stopper, Chipping-Stopper etc. verfügt. Die Maßnahmen (a) und (b) können in vorteilhafter Weise gemeinsam angewandt werden. Selbstverständlich ist es aber auch möglich, eine Hochvolt-Diode zu schaffen, die nur eine dieser Maßnahmen realisiert.

Bei der erfindungsgemäßen Hochvolt-Diode kann es sich um eine schnelle schaltfeste Diode oder aber auch um eine Gleichrichter- und Universal-Diode in verschiedenen Spannungs- und Stromklassen handeln. Die Hochvolt-Diode kann einen oder mehrere Feldringe abhängig von der gewünschten Spannungsklasse in ihrem Randbereich haben.

In bevorzugter Weise besteht bei der erfindungsgemäßen Hochvolt-Diode der Halbleiterkörper aus n-leitendem Silizium, in das eine p-leitende wannenförmige Zone eingebracht ist.

Anstelle eines n-leitenden Siliziumkörpers kann aber auch ein p-leitender Siliziumkörper mit einer n-leitenden wannenförmigen Zone vorgesehen werden.

Das Halbleitermaterial ist nicht auf Silizium begrenzt. Anstelle von Silizium kann beispielsweise auch SiC oder ein A_{III}B_{V}-Halbleitermaterial eingesetzt werden.

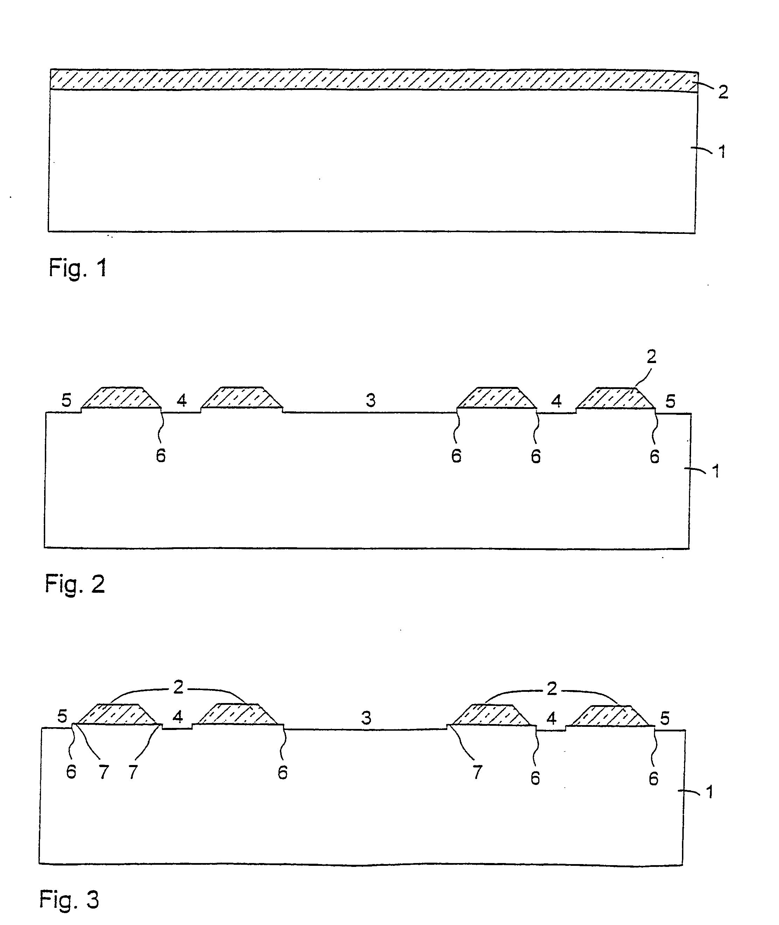

Nachfolgend wird die Erfindung anhand von Zeichnungen näher erläutert, in deren Fig. 1 bis 5 verschiedene Schritte zur Herstellung der erfindungsgemäßen Hochvolt-Diode dargestellt sind.

Fig. 1 zeigt ein n-leitendes Siliziumsubstrat 1, auf das beispielsweise in einem Ofenprozess mit feuchter Oxidation auf der Vorderseite eine etwa 0,5 µm dicke Siliziumdioxidschicht 2 aufgebracht wird. Anstelle von Silizumdioxid kann gegebenenfalls für diese Schicht 2 auch ein anderes Material, beispielsweise Siliziumnitrid, gewählt werden.

In der Siliziumdioxidschicht 2 werden sodann Strukturen für die Anode der Diode und gegebenenfalls im Randbereich für Feldringe mittels Fotolithografie eingebracht. Hierzu wird auf die Siliziumdioxidschicht 2 eine Fotolackschicht aufgetragen, belichtet und entwickelt. Bei dieser Entwicklung werden die Bereiche der Fotolackschicht, in denen die Anode und gegebenenfalls Feldringe erzeugt werden sollen, entfernt. Auf die so freiliegende Siliziumdioxidschicht 2 wird ein Ätzmittel, beispielsweise während einer nasschemischen Ätzung, zur Einwirkung gebracht, um in den genannten Bereichen die Siliziumdioxidschicht zu entfernen.

Es schließt sich sodann ein weiterer Ätzschritt an, bei welchem ein Silizium-Abtrag von beispielsweise 10 ... 1000 nm, vorzugsweise 50 ... 200 nm in der freiliegenden Oberfläche des Siliziumsubstrates 1, also in den Bereichen der in die Siliziumdioxidschicht 2 eingebrachten "Fenster" vorgenommen wird. Dieser Silizium-Abtrag kann über den noch vorhandenen Fotolack oder über die nach Entfernung des Fotolackes verbleibende Siliziumdioxidschicht 2 vorgenommen werden. Damit wird die in Fig. 2 gezeigte Anordnung erhalten, welche auf dem Siliziumsubstrat 1 die verbleibenden Teile der Siliziumdioxidschicht 2 und in Fenstern 3 bis 5 für eine Anode (Fenster 3), einen Feldring (Fenster 4) und Justage-Strukturen zeigt, die in einem Ritzrahmen am Rand des jeweiligen Halbleiterchips (in Fig. 2 rechter Rand) definiert werden (Fenster 5). Anstelle eines Feldringes können auch mehrere Feldringe vorgesehen sein. Gegebenenfalls kann auf die Feldringe auch verzichtet werden. Die Justage erfolgt an Justage-Strukturen bildenden verbleibenden Kanten oder Stufen 6 des Fensters 5.

Bei der Ätzung des Siliziumsubstrates 1 in den Fenstern 3 bis 5 kann über die noch vorliegende Lackmaske die Siliziumdioxidschicht weiter nasschemisch zurückgeätzt werden, um einen gewissen Abstand 7 zwischen später in den Fenstern 3 bis 5 einzubringenden p-Dotierungen und den Kanten 6 der Justage-Strukturen bzw. der durch diese gebildeten Stufe im Siliziumsubstrat 1 zu erzeugen. Spätestens nach diesem gegebenenfalls erfolgenden Rückätzen wird der verbleibende Fotolack entfernt. Damit liegt die in Fig. 2 (ohne zusätzliches Rückätzen des Siliziumsubstrates) bzw. in Fig. 3 (mit zusätzlichem Rückätzen des Siliziumsubstrates) gezeigte Anordnung vor.

Es sei noch angemerkt, dass im vorliegenden Ausführungsbeispiel der Silizium-Abtrag in den Fenstern 3 bis 5 vorgenommen wird. Zumindest erfolgt dieser Abtrag im Fenster 3, um im Bereich einer Wanne 8 außerhalb eines Anodenkontaktes 13 (vgl. unten) eine Kante bzw. Stufe als Justage-Struktur zu erzeugen.

Die in Fig. 2 gezeigte Anordnung kann also in der Weise erzeugt werden, dass der Silizium-Abtrag in den Fenstern 3 bis 5 über die verbleibende Siliziumdioxidschicht 2 (Oxidmaske) bzw. über den auf dieser Siliziumdioxidschicht 2 noch vorhandenen Fotolack erfolgt.

Im Folgenden wird davon ausgegangen, dass die Anordnung von Fig. 3 weiterverarbeitet wird. Es ist jedoch auch möglich, die Anordnung von Fig. 2 in entsprechender Weise zu verarbeiten. In diesem Fall ist aber der Abstand 7 zwischen dem Rand der verbleibenden Siliziumdioxidschicht 2 und den Kanten 6 der Justage-Strukturen nicht vorhanden. Vielmehr schließen sich diese Kanten 6 der Justage-Strukturen dann lagemäßig direkt an den Rand der Fenster 3 bis 5 an.

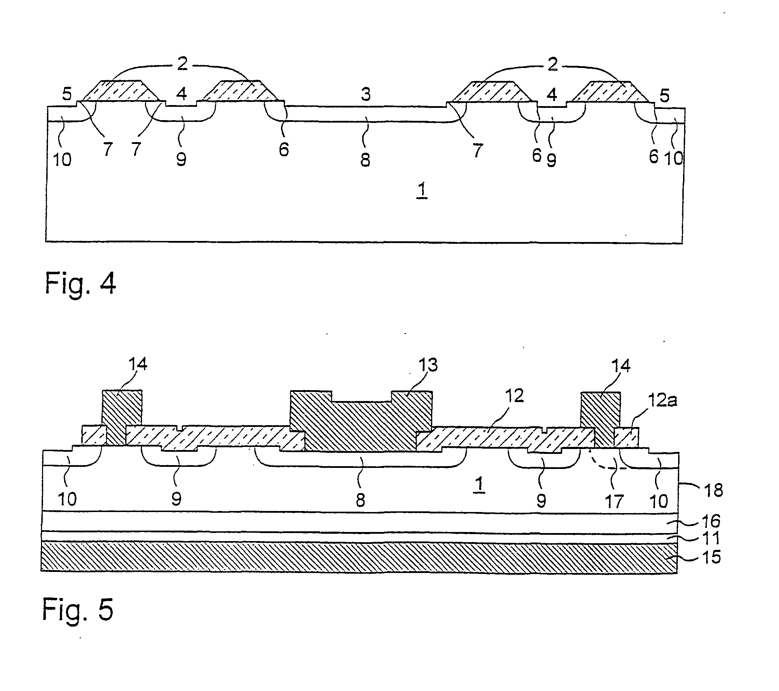

Es folgt sodann eine p-Dotierung, beispielsweise mit Bor, um eine p-leitende wannenförmige Zone 8, einen p-leitenden Feldring 9 und im Bereich des Chipping-Stoppers einen p-leitenden Ring 10 zu erzeugen, wie diese in Fig. 4 dargestellt sind. Die wannenförmige Zone 8 sowie der Feldring 9 und der Ring 10 können beispielsweise einstufig mittels Ionenimplantation oder auch mehrstufig hergestellt werden. So ist es speziell bei schnell schaltenden Dioden für die Zone 8 möglich, diese mit einem p⁺-leitenden Anoden-emitter von geringer Eindringtiefe zu versehen, dessen Dotierstoff-Dosis zwischen 1,3 x 10¹²Dotierstoff-Atomen cm⁻² und 5 x 10¹³ Dotierstoffatomen cm⁻² liegt, und den Rest der Zone 8 mit einer Dosis von etwa (1,3 ... 3) x 10¹² Dotierstoffatomen cm⁻² zu dotieren (vgl. hierzu auch DE-A1-100 31 461).

Für die Weiterprozessierung der in Fig. 4 gezeigten Anordnung gibt es nun verschiedene Varianten, bei denen notwendige Prozessschritte, wie das Einbringen einer n-Dotierung (beispielsweise Phosphor) auf der Rückseite des Halbleitersubstrates 1, also der Scheibenrückseite, als Rückseiten-Emitter zur Bildung einer n⁺-leitenden Siliziumschicht 11 beispielsweise durch Ionenimplantation, das Abätzen der verbleibenden Siliziumdioxidschicht 2 (Opferoxid) auf der Scheibenvorderseite, das Aufbringen und Strukturieren einer Randpassivierungsschicht 12 mit einem Chipping-Stopper 12a aus jeweils insbesondere mit Wasserstoff dotiertem amorphem Kohlenstoff (a-C:H) unter Verwendung eines Lithographieschrittes, das Abscheiden und die Strukturierung einer Vorderseitenmetallisierung aus beispielsweise AlSi zur Bildung eines Anodenkontaktes 13 und eines Kanal-Stoppers 14 und das Abscheiden einer Rückseitenmetallisierung aus beispielsweise AlSi zur Bildung eines Kathodenkontaktes 15 sowie fakultative Prozessschritte, wie das Dünnschleifen bzw. Ätzen des Siliziumsubstrates 1 von der Rückseite auf Enddicke, das Einbringen einer n-leitenden Dotierung als Feldstoppschicht 16 auf der Scheibenrückseite und Ausdiffusion dieser n-leitenden Dotierung, das Einbringen von Schwermetallatomen zur Ladungsträgerlebensdauer-Einstellung, die Schwermetalldiffusion, die Bestrahlung zur Ladungsträgerlebensdauer-Einstellung, das Tempern der Vorderseitenmetallisierung und das Tempern des Rückseitenmetalls vorgenommen werden. Bei diesen Prozeßschritten werden, soweit erforderlich, die Kanten 6 als Justage-Strukturen verwendet. Dabei ist es sogar möglich, die p-leitenden Dotierungen für die Zone 8, den Feldring 9 und den Ring 10, also das Einbringen des Vorderseiten-p-Kontaktes bzw. des p-leitenden Emitters mit Ionenimplantation zu einem späteren Zeitpunkt vorzunehmen.

Diese einzelnen Prozessvarianten sind in der folgenden Tabelle zusammengestellt. Dabei ist die Prozessvariante 1 besonders für Grundmaterial geeignet, das aus durch Zonenziehen (FZ) erhaltenen Silizium-Substratscheiben besteht, während die Prozessvarianten 2 und 3 auch für Czochralski-(CZ-) Substratscheiben oder für mit epitaktischen Schichten versehene bzw. diffundierte ("diffused") Wafer vorteilhaft sind.

Die Randpassivierungsschicht 12 (und damit der Chipping-Stopper 12a) kann gegebenenfalls auch aus amorphen Silizium (a-Si) bestehen.

| Prozessvariante 1 für: Grundmaterial: Si-FZ-Substratscheiben | Prozessvariante 2 für: Grundmaterial: Si-FZ-/CZ-Substratscheiben oder Epi- bzw. Diffused Wafer | Prozessvariante 3 für: Grundmaterial: Si-FZ-/CZ-Substratscheiben oder Epi- bzw. Diffused Wafer |
|---|---|---|
| Dünnschleifen/Ätzen auf Enddicke | | |
| Ggf. Einbringen einer n-Dotierung auf der Scheibenrückseite als Rückseiten-Emitter z. B. mit Ionenimplantation | | |
| Ggf. Einbringen von Schwermetallatomen zur Ladungsträgerlebensdauer-Einstellung | Ggf. Einbringen von Schwermetallatomen zur Ladungsträgerlebensdauer-Einstellung | Ggf. Einbringen von Schwermetallatomen zur Ladungsträgerlebensdauer-Einstellung |
| Ggf. Schwermetalldiffusion | Ggf. Schwermetalldiffusion | Ggf. Schwermetalldiffusion Dünnschleifen/Ätzen auf Enddicke |
| | | Ggf. Einbringen eines n-Rückseitenkontakts z. B. durch Implantation mit nachfolgendem Ausheilschritt |
| Ggf. jetzt erst Einbringen des Vorderseiten-p-Kontakts/p-Emitters mit Ionenimplantation | Ggf. jetzt erst Einbringen des Vorderseiten-p-Kontakts/p-Emitters mit Ionenimplantation | Ggf. jetzt erst Einbringen des Vorderseiten-p-Kontakts/p-Emitters mit Ionenimplantation |
| Abätzen des Opferoxids auf der Vorderseite | Abätzen des Opferoxids auf der Vorderseite | Abätzen des Opferoxids auf der Vorderseite |
| Ggf. Bestrahlung zur Ladungsträgerlebensdauer-Einstellung | Ggf. Bestrahlung zur Ladungsträgerlebensdauer-Einstellung | Ggf. Bestrahlung zur Ladungsträgerlebensdauer-Einstellung |
| Aufbringen der Randpassivierung, z. B. aus a-C:H | Aufbringen der Randpassivierung, z. B. aus a-C:H | Aufbringen der Randpassivierung, z. B. aus a-C:H |
| Ggf. Bestrahlung zur Ladungsträgerlebensdauer-Einstellung | Ggf. Bestrahlung zur Ladungsträgerlebensdauer-Einstellung | Ggf. Bestrahlung zur Ladungsträgerlebensdauer-Einstellung |
| Abscheiden/Strukturieren der Vorderseiten-Metallisierung z. B. aus AlSi | Abscheiden/Strukturieren der Vorderseiten-Metallisierung z. B. aus AlSi | Abscheiden/Strukturieren der Vorderseiten-Metallisierung z. B. aus AlSi |
| Ggf. Tempern der Vorderseiten-Metallisierung | Ggf. Tempern der Vorderseiten-Metallisierung | Ggf. Tempern der Vorderseiten-Metallisierung |
| Ggf. Bestrahlung zur Ladungsträgerlebensdauer-Einstellung | Ggf. Bestrahlung zur Ladungsträgerlebensdauer-Einstellung | Ggf. Bestrahlung zur Ladungsträgerlebensdauer-Einstellung |
| | Dünnschleifen/Ätzen auf Enddicke | |
| | Einbringen einer n-Dotierung auf der Scheibenrückseite als Rückseiten-kontakt z. B. mit Ionenimplantation | |
| Abscheiden Rückseitenmetall | Abscheiden Rückseitenmetall | Abscheiden Rückseitenmetall |
| Ggf. Tempern des Rückseitenmetalls | Ggf. Tempern des Rückseitenmetalls | Ggf. Tempern des Rückseitenmetalls |

Bei den obigen verschiedenen Prozessvarianten wird der Prozessschritt "Ggf. Bestrahlung zur Ladungsträgerlebensdauer-Einstellung" mehrmals vorgenommen, da je nach verwendeter Dosis bei der Ionenimplantation und Strahlenart unterschiedlich hohe Temperaturbudgets zur Ausheilung von Strahlenschäden erforderlich sind.

Die insbesondere aus mit Wasserstoff dotiertem amorphem Kohlenstoff bestehende Randpassivierungsschicht 12 wirkt teilweise als Chipping-Stopper 12a und verhindert die Ausbreitung von Kristalldefekten ausgehend von einem Ritzrahmen in ein aktives Gebiet beim Vereinzeln bzw. Sägen einer Siliziumscheibe in Chips. Im Ritzrahmen selbst ist dabei die Passivierungsschicht 12 analog zu den Kontaktlöchern für den Anodenkontakt 13 und den Kanal-Stopper 14 geöffnet, wobei hier aber keine Abdeckung mit Metall erfolgt.

Der Kanal-Stopper 14 wirkt als Feldplatte und verhindert die weitere Ausbreitung einer Raumladungszone nach außen in den Ritzrahmen. Dadurch ist es möglich, die notwendige Randbreite speziell bei einem hochohmigen Grundmaterial für das Siliziumsubstrat 1 zu reduzieren.

Der Kanal-Stopper 14 kann auch mit einem p-leitenden Gebiet verbunden sein, wie dies durch eine gestrichelte Linie 17 in Fig. 5 angedeutet ist. Dieses p-leitende Gebiet sollte dann das gleiche elektrische Potenzial wie die Rückseite des Siliziumsubstrates haben, also mit dem Kathodenkontakt 15 verbunden sein.

Besonders vorteilhaft ist es aber, wenn der Kanalstopper 14 direkt mit einem n-leitenden Gebiet verbunden ist, wie dies in Fig. 5 gezeigt ist.

Zusätzlich zu dem Feldring 9 können gegebenenfalls zwischen dem aktiven Gebiet, also der wannenförmigen Zone 8, und einem Sägerand 18 noch weitere Feldringe 9 vorhanden sein, die zudem alle oder teilweise mit Metallstrukturen versehen sein können. Auch kann der Feldring 9 eine solche Metallstruktur haben.

Die erfindungsgemäße Hochvolt-Diode lässt sich dank der Justage-Strukturen 6, die außerhalb des Anodenkontaktes 13 gelegen sind, und der Ausführung des Chipping-Stoppers 12a im Randbereich durch die Passivierungsschicht 12 mittels lediglich insgesamt drei Maskierungsschritten für die Erzeugung der strukturierten Siliziumdioxidschicht 2, der Passivierungsschicht 12 und der Vorderseitenmetallisierung aus dem Anodenkontakt 13 und dem Kanal-Stopper 14 herstellen. In vorteilhafter Weise kann dabei die Justage-Struktur 6 ausgenutzt werden, die ein genaues Positionieren beispielsweise des Anodenkontaktes 13 und des Kanal-Stoppers 14 erlaubt.

### Bezugszeichenliste

- 1: Siliziumsubstrat
- 2: Siliziumdioxidschicht
- 3: Fenster für Wanne
- 4: Fenster für Feldring
- 5: Fenster für Chipping-Stopper-Ring
- 6: Kante
- 7: Abstand
- 8: wannenförmige Zone
- 9: Feldring
- 10: Chipping-Stopper-Ring
- 11: n⁺-leitende Siliziumschicht
- 12: Passivierungsschicht
- 12a: Chipping-Stopper
- 13: Anodenkontakt
- 14: Kanal-Stopper
- 15: Kathodenkontakt
- 16: Feldstoppschicht
- 17: gestrichelte Linie für p-leitendes Gebiet
- 18: Sägerand

## Patentansprüche

1. Hochvolt-Diode mit:
- einer wannenförmigen Zone (8) des einen Leitungstyps, die in einer ersten Hauptoberfläche eines Halbleiterkörpers (1) des anderen, zum einen Leitungstyp entgegengesetzten Leitungstyps vorgesehen ist,
- einem auf der wannenförmigen Zone (8) vorgesehenen Metallkontakt (13),
- einer dem Metallkontakt (13) gegenüber liegenden Rückseitenmetallisierung (15) auf einer der ersten Hauptoberfläche gegenüber liegenden zweiten Hauptoberfläche des Halbleiterkörpers (1),
- einem Randabschluss mit einem Kanal-Stopper (14) und
- einer Passivierungsschicht (12), die auf der ersten Hauptoberfläche im Bereich zwischen dem Metallkontakt (13) und dem Kanal-Stopper (14) vorgesehen ist und den an die erste Hauptoberfläche tretenden pn-Übergang bedeckt,
**dadurch gekennzeichnet, daß**
- die Passivierungsschicht (12) aus amorphem, mit Wasserstoff dotiertem Kohlenstoff oder aus amorphem Silizium besteht und im Bereich des Halbleiterkörpers (1) außerhalb des Kanal-Stoppers (14) als Chipping-Stopper (12a) dient und
- in der ersten Hauptoberfläche im Bereich der wannenförmigen Zone (8) mindestens eine Kante (6) als Justage-Struktur vorgesehen ist.

2. Hochvolt-Diode nach Anspruch 1,
**dadurch gekennzeichnet , dass**
der Randabschluß einen oder mehrere Feldringe (9) aufweist.

3. Hochvolt-Diode der Ansprüche 1 oder 2,
**dadurch gekennzeichnet , dass**
der Kanal-Stopper (14) auf dem Halbleiterkörper (1) vorgesehen ist.

4. Hochvolt-Diode nach einem der Ansprüche 1 bis 3,
**dadurch gekennzeichnet, dass**
der Kanal-Stopper (14) auf einem Gebiet des einen Leitungstyps vorgesehen ist.

5. Hochvolt-Diode nach einem der Ansprüche 1 bis 4,
**dadurch gekennzeichnet, dass**
zwischen dem Halbleiterkörper (1) und einer Kathodenmetallisierung (15) eine Feldstoppschicht (16) des anderen Leitungstyps und eine hochdotierte Emitterschicht (11) des anderen Leitungstyps vorgesehen sind.

6. Hochvolt-Diode nach einem der Ansprüche 1 bis 5,
**dadurch gekennzeichnet, dass**
die Justage-Strukturen (6) aus Siliziumstufen in der ersten Hauptoberfläche mit einer Höhe von etwa 10 ... 1000 nm, vorzugsweise 50 ... 200 nm bestehen.

7. Hochvolt-Diode nach einem der Ansprüche 1 bis 6,
**dadurch gekennzeichnet, dass**
die Justage-Strukturen (6) außerhalb des Anodenkontaktes (13) gelegen sind.

8. Hochvolt-Diode nach einem der Ansprüche 1 bis 7,
**dadurch gekennzeichnet, dass**
die Passivierungsschicht (12) nicht bis zum Sägerand (18) des Halbleiterkörpers reicht.

9. Hochvolt-Diode nach einem der Ansprüche 1 bis 8,
**dadurch gekennzeichnet, dass**
im Bereich des Sägerandes (18) eine ringförmige Zone (10) des einen Leitungstyps an der ersten Hauptoberfläche freiliegen kann.

10. Hochvolt-Diode nach einem der Ansprüche 1 bis 9,
**dadurch gekennzeichnet, dass**
die wannenförmige Zone (8) des einen Leitungstyps mit einer Dosis von (1,3 ... 3) x 10¹² Dotierstoffatomen cm⁻² dotiert ist, um die Hochvolt-Diode als schnelle Freilaufdiode zu betreiben.

11. Hochvolt-Diode nach Anspruch 10,
**dadurch gekennzeichnet, dass**
ein Oberflächenbereich der wannenförmigen Zone (8) mit einer Dosis zwischen 1,3 x 10¹² Dotierstoffatomen cm⁻² und 5 x 10¹³ Dotierstoffatomen cm⁻² dotiert ist.

12. Verfahren zum Herstellen der Hochvolt-Diode nach einem der Ansprüche 1 bis 11,
**gekennzeichnet durch**
die folgenden Verfahrensschritte:
(a) Erzeugen einer Maskenisolierschicht (2) auf einem Halbleiterkörper (1),
(b) Strukturieren der Maskenisolierschicht (2) zur Erzeugung wenigstens eines Fensters (3, 4, 5) für eine wannenförmige Zone (8),
(c) Erzeugen von Stufen als Justage-Strukturen (6) im Siliziumkörper (1) **durch** die Fenster (3, 4, 5),
(d) Erzeugen der wannenförmigen Zone (8) **durch** das Fenster (3) mit jeweils einem zum Leitungstyp des Halbleiterkörpers (1) entgegengesetzten Leitungstyp,
(e) Entfernen der strukturierten Maskenisolierschicht (2),
(f) Aufbringen und mittels eines mit den Justage-Strukturen (6) justierten Lithographieschrittes Strukturieren einer Passivierungsschicht (12) aus amorphem, mit Wasserstoff dotiertem Kohlenstoff oder aus amorphem Silizium,
(g) Aufbringen und Strukturieren eines Metallkontaktes (13) und eines Kanal-Stoppers (14) in Fenstern der strukturierten Passivierungsschicht (12) auf einer Vorderseite der wannenförmigen Zone (8) bzw. des Halbleiterkörpers (1) und
(h) Aufbringen einer Metallisierung (15) auf der Rückseite des Halbleiterkörpers (1).

13. Verfahren nach Anspruch 12,
**dadurch gekennzeichnet, dass**
bei Verfahrensschritt (b) ein Strukturieren für einen Feldring (9) und einen Chipping-Stopper-Ring (10) vorgenommen wird.

14. Verfahren nach Anspruch 12 oder 13,
**dadurch gekennzeichnet, dass**
vor oder nach dem Verfahrensschritt (d) wenigstens einer der folgenden Verfahrensschritte durchgeführt wird:
(i) Dünnschleifen und/oder Ätzen des Halbleiterkörpers (1) auf Enddicke,
(j) Einbringen einer Dotierung des anderen Leitungstyps als Feldstoppschicht (16) auf der Rückseite des Halbleiterkörpers (1) und Ausdiffusion dieser Dotierung,
(k) Einbringen einer n-leitenden Dotierung auf der Rückseite des Halbleiterkörpers (1) als Rückseiten-Emitter (11) insbesondere durch Ionenimplantation,
(l) Einbringen von Schwermetallatomen zur Ladungsträgerlebensdauer-Einstellung und
(m) Diffusion der Schwermetallatome.

15. Verfahren nach den Ansprüchen 12 und 14,
**dadurch gekennzeichnet, dass**
einer der Verfahrensschritte (1) und (m) vor oder nach dem Verfahrensschritt (d) durchgeführt wird.

16. Verfahren nach den Ansprüchen 12 und 14,
**dadurch gekennzeichnet, dass**
die Verfahrensschritte (i) bis (k) nach den Verfahrensschritten (1) und (m) durchgeführt werden.

17. Verfahren nach einem der Ansprüche 12 bis 16,
**dadurch gekennzeichnet, dass**
nach dem Verfahrensschritt (e) und vor dem Verfahrensschritt (f) der folgende Verfahrensschritt durchgeführt wird:
(n) Bestrahlen des Halbleiterkörpers (1) und/oder darin enthaltenen Zonen (8) und Ringe (9, 10) zur Ladungsträgerlebensdauer-Einstellung.

18. Verfahren nach einem der Ansprüche 12 bis 17,
**dadurch gekennzeichnet, dass**
nach dem Verfahrensschritt (f) und vor dem Verfahrensschritt (g) der folgende Verfahrensschritt durchgeführt wird: (o) Bestrahlen des Halbleiterkörpers (1) und/oder der darin enthaltenen Zonen (8) und Ringe (9, 10) zur Ladungsträgerlebensdauer-Einstellung.

19. Verfahren nach einem der Ansprüche 12 bis 18,
**dadurch gekennzeichnet, dass**
nach dem Verfahrensschritt (g) wenigstens einer der folgenden Verfahrensschritte durchgeführt wird:
(p) Tempern der Vorseiten-Metallisierung aus dem Metallkontakt (13) und dem Kanal-Stopper (14) und
(q) Bestrahlen des Halbleiterkörpers (1) und der darin enthaltenen Zonen (8) und Ringe (9, 10) zur Ladungsträgerlebensdauer-Einstellung.

20. Verfahren nach einem der Ansprüche 12 bis 19,
**dadurch gekennzeichnet, dass**
die Verfahrensschritte (i) und (k) nach dem Verfahrensschritt (q) durchgeführt werden.

21. Verfahren nach einem der Ansprüche 12 bis 20,
**dadurch gekennzeichnet, dass**
nach dem Verfahrensschritt (h) der folgende Verfahrensschritt durchgeführt wird:
(r) Tempern der Metallisierung (15) auf der Rückseite des Halbleiterkörpers.

22. Verfahren nach einem der Ansprüche 12 bis 21,
**dadurch gekennzeichnet, dass**
die Maskenisolierschicht (2) in einem Ofenprozess mit feuchter Oxidation bis zu einer Schichtdicke von etwa 0,5 µm durchgeführt wird.

23. Verfahren nach einem der Ansprüche 12 bis 22,
**dadurch gekennzeichnet, dass**
die Justage-Strukturen (6) bis zu einer Tiefe von 10 ... 1000 nm, vorzugsweise 50 ... 200 nm in den Halbleiterkörper (1) durch Ätzen eingebracht werden.

24. Verfahren nach Anspruch 23,
**dadurch gekennzeichnet, dass**
für das Ätzen eine isotrope Ätzung durchgeführt wird.

25. Verfahren nach einem der Ansprüche 12 bis 24,
**dadurch gekennzeichnet, dass**
die Justage-Strukturen (6) mit einem Abstand (7) gegenüber den Fenstern (3, 4, 5) versehen werden.

26. Verfahren nach einem der Ansprüche 12 bis 25,
**dadurch gekennzeichnet, dass**
zur Herstellung der Hochvolt-Diode nur drei Fototechnik-Schritte durchgeführt werden.

## Claims

1. High-voltage diode having:
- a well-type zone (8) of the first conduction type, which is provided in a first main surface of a semiconductor body (1) of the second conduction type, opposite to the first conduction type,
- a metal contact (13) provided on the well-type zone (8),
- a rear side metallization (15) - located opposite to the metal contact (13) - on a second main surface of the semiconductor body (1), said second main surface being located opposite to the first main surface,
- an edge termination with a channel stopper (14), and
- a passivation layer (12), which is provided on the first main surface in the region between the metal contact (13) and the channel stopper (14) and covers the pn junction issuing at the first main surface,
**characterized in that**
- the passivation layer (12) comprises amorphous carbon doped with hydrogen, or amorphous silicon and serves as chipping stopper (12a) in the region of the semiconductor body (1) outside the channel stopper (14), and
- at least one edge (6) is provided as an alignment structure in the first main surface in the region of the well-type zone (8).

2. High-voltage diode according to Claim 1,
**characterized in that**
the edge termination has one or a plurality of field rings (9).

3. High-voltage diode of Claims 1 or 2,
**characterized in that**
the channel stopper (14) is provided on the semiconductor body (1).

4. High-voltage diode according to one of Claims 1 to 3,
**characterized in that**
the channel stopper (14) is provided on a region of the first conduction type.

5. High-voltage diode according to one of Claims 1 to 4,
**characterized in that**
a field stop layer (16) of the second conduction type and a highly doped emitter layer (11) of the second conduction type are provided between the semiconductor body (1) and a cathode metallization (15).

6. High-voltage diode according to one of Claims 1 to 5,
**characterized in that**
the alignment structures (6) comprise silicon steps in the first main surface with a height of about 10 ... 1 000 nm, preferably 50 ... 200 nm.

7. High-voltage diode according to one of Claims 1 to 6,
**characterized in that**
the alignment structures (6) are located outside the anode contact (13).

8. High-voltage diode according to one of Claims 1 to 7,
**characterized in that**
the passivation layer (12) does not reach as far as the sawing edge (18) of the semiconductor body.

9. High-voltage diode according to one of Claims 1 to 8,
**characterized in that**,
in the region of the sawing edge (18), an annular zone (10) of the first conduction type can be uncovered at the first main surface.

10. High-voltage diode according to one of Claims 1 to 9,
**characterized in that**
the well-type zone (8) of the first conduction type is doped with a dose of (1.3 ... 3) × 10¹² dopant atoms cm⁻² in order to operate the high-voltage diode as a fast freewheeling diode.

11. High-voltage diode according to Claim 10,
**characterized in that**
a surface region of the well-type zone (8) is doped with a dose of between 1.3 × 10¹² dopant atoms cm⁻² and 5 × 10¹³ dopant atoms cm⁻².

12. Method for fabricating the high-voltage diode according to one of Claims 1 to 11,
**characterized by**
the following method steps:
(a) production of a mask insulating layer (2) on a semiconductor body (1),
(b) patterning of the mask insulating layer (2) for the purpose of producing at least one window (3, 4, 5) for a well-type zone (8),
(c) production of steps as alignment structures (6) in the silicon body (1) through the windows (3, 4, 5),
(d) production of the well-type zone (8) through the window (3) with in each case a conduction type opposite to the conduction type of the semiconductor body (1),
(e) removal of the patterned mask insulating layer (2),
(f) application and, by means of a lithography step aligned using the alignment structures (6), patterning of a passivation layer (12) made of amorphous carbon doped with hydrogen, or made of amorphous silicon,
(g) application and patterning of a metal contact (13) and of a channel stopper (14) in windows of the patterned passivation.layer (12) on a front side of the well-type zone (8) and of the semiconductor body (1) respectively, and
(h) application of a metallization (15) on the rear side of the semiconductor body (1).

13. Method according to Claim 12,
**characterized in that**
in method step (b) a patterning for a field ring (9) and a chipping stopper ring (10) is performed.

14. Method according to Claim 12 or 13,
**characterized in that**
before or after method step (d), at least one of the following method steps is carried out:
(i) thinning by grinding and/or etching of the semiconductor body (1) to a final thickness,
(j) introduction of a doping of the second conduction type as field stop layer (16) on the rear side of the semiconductor body (1) and outdiffusion of this doping,
(k) introduction of an n-conducting doping on the rear side of the semiconductor body (1) as rear side emitter (11), in particular by ion implantation,
(l) introduction of heavy metal atoms for the purpose of setting the charge carrier lifetime, and
(m) diffusion of the heavy metal atoms.

15. Method according to Claims 12 and 14,
**characterized in that**
one of the method steps (1) and (m) is carried out before or after method step (d).

16. Method according to Claims 12 and 14,
**characterized in that**
method steps (i) to (k) are carried out after method steps (1) and (m).

17. Method according to one of Claims 12 to 16,
**characterized in that**
the following method step is carried out after method step (e) and before method step (f):
(n) irradiation of the semiconductor body (1) and/or zones (8) and rings (9, 10) contained therein for the purpose of setting the charge carrier lifetime.

18. Method according to one of Claims 12 to 17,
**characterized in that**
the following method step is carried out after method step (f) and before method step (g):
(o) irradiation of the semiconductor body (1) and/or zones (8) and rings (9, 10) contained therein for the purpose of setting the charge carrier lifetime.

19. Method according to one of Claims 12 to 18,
**characterized in that**
after method step (g) at least one of the following method steps is carried out:
(p) heat treatment of the front side metallization made of the metal contact (13) and the channel stopper (14), and
(q) irradiation of the semiconductor body (1) and the zones (8) and rings (9, 10) contained therein for the purpose of setting the charge carrier lifetime.

20. Method according to one of Claims 12 to 19,
**characterized in that**
method steps (i) and (k) are carried out after method step (q).

21. Method according to one of Claims 12 to 20,
**characterized in that**
the following method step is carried out after method step (h):
(r) heat treatment of the metallization (15) on the rear side of the semiconductor body.

22. Method according to one of Claims 12 to 21,
**characterized in that**
the mask insulating layer (2) is implemented in a furnace process with moist oxidation up to a layer thickness of about 0.5 µm.

23. Method according to one of Claims 12 to 22,
**characterized in that**
the alignment structures (6) are introduced into the semiconductor body (1) by etching down to a depth of 10 ... 1 000 nm, preferably 50 ... 200 nm.

24. Method according to Claim 23,
**characterized in that**
an isotropic etching is carried out for the etching.

25. Method according to one of Claims 12 to 24,
**characterized in that**
the alignment structures (6) are provided with a spacing (7) with respect to the windows (3, 4, 5).

26. Method according to one of Claims 12 to 25,
**characterized in that**
only three phototechnology steps are carried out for the fabrication of the high-voltage diode.

## Revendications

1. Diode haute tension comprenant :
- une zone (8) en forme de cuvette d'un type de conductivité, qui est prévue dans une première surface principale d'un corps (1) semi-conducteur de l'autre type de conductivité opposé au un type de conductivité,
- un contact (13) métallique prévu sur la zone (8) en forme de cuvette,
- une métallisation (15) de face arrière opposée au contact (13) métallique sur une deuxième surface principale du corps (1) semi-conducteur opposée à la première surface principale,
- une fermeture de bord ayant un canal-stopper (14) et
- une couche (12) de passivation qui est prévue sur la première surface principale dans la zone comprise entre le contact (13) métallique et le canal-stopper (14) et qui recouvre la jonction pn apparaissant sur la première surface principale,
**caractérisée en ce que**
- la couche (12) de passivation est en carbone amorphe dopé par de l'hydrogène ou en silicium amorphe et sert dans la zone du corps (1) semi-conducteur à l'extérieur du canal-stopper (14) de chipping-stopper (12a) et
- il est prévu dans la première surface principale, dans la partie de la zone (8) en forme de cuvette, au moins un bord (6) comme structure d'alignement.

2. Diode haute tension suivant la revendication 1,
**caractérisée en ce que** la fermeture de bord comporte une ou plusieurs bagues (9) de champ.

3. Diode haute tension suivant la revendication 1 ou 2,
**caractérisée en ce que** le canal-stopper (14) est prévu sur le corps (1) semi-conducteur.

4. Diode haute tension suivant l'une des revendications 1 à 3,
**caractérisée en ce que** le canal-stopper (14) est prévu sur une région du un type de conductivité.

5. Diode haute tension suivant l'une des revendications 1 à 4,
**caractérisée en ce qu'**il est prévu entre le corps (1) semi-conducteur et une métallisation (15) de cathode une couche (16) d'arrêt de champ de l'autre type de conductivité et une couche (11) d'émetteur très dopée de l'autre type de conductivité.

6. Diode haute tension suivant l'une des revendications 1 à 5,
**caractérisée en ce que** les structures (6) d'alignement sont constituées de paliers de silicium dans la première surface principale d'une hauteur d'environ 10 ... 1000 nm, de préférence 50 ... 200 nm.

7. Diode haute tension suivant l'une des revendications 1 à 6,
**caractérisée en ce que** les structures (6) d'alignement sont mises à l'extérieur du contact (13) d'anode.

8. Diode haute tension suivant l'une des revendications 1 à 7,
**caractérisée en ce que** la couche (12) de passivation ne va pas jusqu'au bord (18) à scier du corps semi-conducteur.

9. Diode haute tension suivant l'une des revendications 1 à 8,
**caractérisée en ce que**, dans la partie du bord (18) à scier, peut être mise à nu une zone (10) annulaire du un type de conductivité sur la première surface principale.

10. Diode haute tension suivant l'une des revendications 1 à 9,
**caractérisée en ce que** la zone (8) en forme de cuvette du un type de conductivité est dopée par une dose de (1,3 ... 3) x 10¹² atomes de substance de dopage cm⁻² pour faire fonctionner la diode haute tension en diode de roue libre rapide.

11. Diode haute tension suivant la revendication 10,
**caractérisée en ce qu'**une partie de la surface de la zone 8 en forme de cuvette est dopée par une dose comprise entre 1,3 x 10¹² atomes de substance de dopage cm⁻² et 5 x 10¹³ atomes de substance de dopage cm⁻².

12. Procédé de production d'une diode haute tension suivant l'une des revendications 1 à 11,
**caractérisé par** les stades de procédé suivants :
(a) production d'une couche (2) isolante de masque sur un corps (1) semi-conducteur,
(b) structuration de la couche (2) isolante de masque pour la production d'au moins une fenêtre (3, 4, 5) pour une zone (8) en forme de cuvette,
(c) production de paliers en tant que structures (6) d'alignement dans le corps (1) en silicium à travers la fenêtre (3, 4, 5),
(d) production de la zone (8) en forme de cuvette à travers la fenêtre (3) ayant respectivement un type de conductivité opposé au type de conductivité du corps (1) semi-conducteur,
(e) élimination de la couche (2) isolante de masque structurée,
(f) dépôt et, au moyen d'un stade de lithographie ajustée par les structures (6) d'alignement, structuration d'une couche (12) de passivation en carbone amorphe dopé par de l'hydrogène ou en silicium amorphe,
(g) dépôt et structuration d'un contact (13) métallique et d'un canal-stopper (14) dans des fenêtres de la couche (12) de passivation structurée sur un côté avant de la zone (8) en forme de cuvette ou du corps (1) semi-conducteur et
(h) dépôt d'une métallisation (15) sur la face arrière du corps (1) semi-conducteur.

13. Procédé suivant la revendication 12,
**caractérisé en ce que**, au stade (b) du procédé, on effectue une structuration pour une bague (9) de champ et une bague (10) de chipping-stopper.

14. Procédé suivant la revendication 12 ou 13,
**caractérisé en ce que**, avant ou après le stade (d) du procédé, on effectue au moins l'un des stades suivants de procédé :
(i) amincissement par abrasion et/ou attaque du corps (1) semi-conducteur jusqu'à une épaisseur finale,
(j) introduction d'un dopage de l'autre type de conductivité que la couche (16) d'arrêt de champ sur le côté arrière du corps (1) semi-conducteur et diffusion de ce dopage,
(k) introduction d'un dopage de conductivité n sur la face arrière du corps (1) semi-conducteur en tant qu'émetteur (11) de face arrière, notamment par implantation d'ions,
(l) introduction d'atomes de métal lourd pour régler la durée de vie des porteurs de charge et
(m) diffusion des atomes de métal lourd.

15. Procédé suivant les revendications 12 et 14,
**caractérisé en ce que** l'on effectue l'un des stades (1) et (m) du procédé avant ou après le stade (d) du procédé.

16. Procédé suivant les revendications 12 et 14,
**caractérisé en ce que** l'on effectue les stades (i) à (k) du procédé après les stades (1) et (m) du procédé.

17. Procédé suivant l'une des revendications 12 à 16,
**caractérisé en ce que** l'on effectue, après le stade (e) du procédé et avant le stade (f) du procédé, le stade de procédé suivant :
(n) insolation du corps (1) semi-conducteur et/ou de zones (8) qui s'y trouvent et de bagues (9, 10) pour régler la durée de vie des porteurs de charge.

18. Procédé suivant l'une des revendications 12 à 17,
**caractérisé en ce que** l'on effectue, après le stade (f) de procédé et avant le stade (g) de procédé, le stade de procédé suivant :
(o) insolation du corps (1) semi-conducteur et/ou des zones (8) qui y sont contenues et des anneaux (9, 10) pour régler la durée de vie des porteurs de charge.

19. Procédé suivant l'une des revendications 12 à 18,
**caractérisé en ce que** l'on effectue, après le stade (g) de procédé, au moins l'un des stades de procédé suivants :
(p) recuit de la métallisation de face avant en le contact (13) métallique et en le canal-stopper (14) et
(q) insolation du corps (1) semi-conducteur et des zones (8) qui s'y trouvent et des bagues (9, 10) pour régler la durée de vie de porteurs de charge.

20. Procédé suivant l'une des revendications 12 à 19,
**caractérisé en ce que** l'on effectue les stades (i) et (k) de procédé après le stade (q) de procédé.

21. Procédé suivant l'une des revendications 12 à 20,
**caractérisé en ce que** l'on effectue, après le stade (h) de procédé, le stade de procédé suivant :
(r) recuit de la métallisation (15) sur la face arrière du corps semi-conducteur.

22. Procédé suivant l'une des revendications 12 à 21,
**caractérisé en ce que** l'on dépose la couche (2) isolante de masque dans un processus au four avec oxydation humide jusqu'à obtention d'une épaisseur de couche d'environ 0,5 µm.

23. Procédé suivant l'une des revendications 12 à 22,
**caractérisé en ce que** l'on introduit par attaque les structures (6) d'alignement jusqu'à une profondeur de 10 ... 1000 nm, de préférence 50 ... 200 nm dans le corps (1) semi-conducteur.

24. Procédé suivant la revendication 23,
**caractérisé en ce qu'**on effectue, pour l'attaque, une attaque isotrope.

25. Procédé suivant l'une des revendications 12 à 24,
**caractérisé en ce que** les structures (6) d'alignement sont à une certaine distance (7) des fenêtres (3, 4, 5).

26. Procédé suivant l'une des revendications 12 à 25,
**caractérisé en ce que**, pour produire la diode haute tension, on n'effectue que trois stades de phototechnique.
